# EUROPEAN PATENT SPECIFICATION

(11) **EP 0 651 063 B1**
(45) Date of publication and mention of the grant of the patent: **10.05.2000**
(21) Application number: 94307892.3
(22) Date of filing: 27.10.1994
(51) Int. Cl.: C22B 7/00, C22B 11/00

(54) **Improvements in or relating to the recovery of silver**
Rückgewinnung von Silber
Récupération d'argent

(30) Priority: 28.10.1993 GB 9322202
(43) Date of publication of application: 03.05.1995
(73) Proprietor: AGFA-GEVAERT N.V., 2640 Mortsel (BE)
(72) Inventor: Kitteridge, John Michael, Leeds, West Yorkshire LS14 2DJ (GB); Mallison, Malcolm James, Leeds, West Yorkshire LS18 4NY (GB)

(56) References cited:
- EP-A- 0 131 462
- EP-A- 0 366 334
- DE-A- 4 122 729
- US-A- 3 288 770
- US-A- 4 318 818
- US-A- 5 071 476
- JOURNAL OF PHOTOGRAPHIC SCIENCE, vol.23, no.6, 1975, LONDON GB pages 240 - 248 R. E. JACOBSON 'The Hydrolysis of Gelatin ......'

## Description

This invention relates to the recovery of silver and is principally concerned with recovering silver from high sensitivity printing plates.

The well-known comparatively high sensitivity to light of silver halides over conventional photopolymeric materials and their ability to respond to light from ultra-violet to infra-red make them ideally suited for use in printing plate applications where direct-to-plate exposure, rather than exposure through a contact film intermediate, is called for.

Silver halides in this context can be used in a variety of ways. Printing plates, in general, include at least one layer of photosensitive material; such a layer may comprise a silver halide in combination with gelatin or other matrix binder. Oxidised developing agent, which is generated on development of exposed silver halide, can crosslink the gelatin or other matrix binder, so providing a tough, ink-receptive image. This technique is often referred to as tanning development. Alternatively, a silver halide emulsion layer can be overcoated onto a conventional photopolymerisable layer of a printing plate. The consequence of the difference in sensitivity between the layers is that, at a given intensity of radiation, a short light exposure can be used to imagewise expose the top silver halide layer which, on development, forms a mask for a longer, blanket, light exposure to convert the polymeric layer into a soluble or insoluble form depending on the nature of the photopolymer.

A third general use of silver halide in printing plate applications is the well known technique of diffusion transfer reversal (DTR). In this method a developer is used which chemically develops exposed areas of the photosensitive coating whilst at the same time dissolving the unexposed areas. The dissolved areas of silver halide, generally in the form of silver thiosulphate or thiocyanate complexes, diffuse to a nucleation layer where metallic silver is formed by reduction of the complexes. This silver can be made oleophilic, for example by use of a mercapto compound such as 1-phenyl-5-mercaptotetrazole, and used as the printing image of a lithographic printing plate.

In the latter two examples in particular, silver in a coated layer is generated as a by-product which plays no part in the final printing process. The problem then arises of recovering this "non-useful" silver.

In DTR systems which comprise two separate sheets, one containing the light sensitive silver halide coating and the other coated with a nucleating agent, the chemically developed silver remaining in the light sensitive layer is the by-product and can be recovered from this layer quite easily by, for example, incinerating the layer.

In the case of masked systems or those instances where an integral DTR system is employed, the chemically developed silver is physically removed with the aid of water or an aqueous wash off solution, and has to be recovered from this medium.

Several methods are provided by the prior art for the recovery of silver, such as filtration, centrifugation and sedimentation. However, these processes are generally only suitable for batchwise applications, and their incorporation in continuous in-line systems, even when possible, usually creates additional difficulties leading to inefficient recovery. Thus, for example, European Patent No. 366,334 describes a sedimentation technique which requires several days for its completion.

In addition it is found that the silver contained in the wash liquor generated from the processing of silver-based printing plates is of very fine particulate size, generally in the region of 0.1 to 1.0 microns, most typically 0.1 to 0.3 microns, in diameter, and consequently its removal by filtration techniques is both difficult and expensive. It has been shown that the addition of flocculating agents to the wash liquor enables these disadvantages to be overcome. However, the presence of flocculating agents inevitably provides further problems in the processing of silver-based printing plates in that the removal of the silver-bearing coating from the substrate becomes more difficult, or even impossible. Such silver-based printing plates typically comprise a silver halide emulsion layer coated on a suitable substrate. The substrate may be suitably treated paper or plastics material, e.g. polyester, or a metal such as aluminium which may be grained and anodised to render its surface more lithographically suitable, or it may be a composite of these materials.

Attempts to alleviate such decoating problems have involved the addition of flocculating agent after the removal of the coating, and subsequent filtration of the flocculated silver from the liquor. However, in order that the waste liquor may be recycled, it is necessary that exactly the correct amount of flocculating agent is added, such that essentially all flocculating agent and silver are removed on filtration; such a process is virtually impossible to control. As an alternative, it is possible that all the filtered liquor may be discharged to waste but this procedure does, of course, involve the disposal of large quantities of liquid.

The present invention seeks to provide a method for the removal of a gelatin based silver-containing coating from an exposed and developed printing plate precursor and the subsequent economic recovery of the silver in a convenient form which minimises pollution.

The present invention also seeks to provide a method of processing a a printing plate precursor comprising a substrate having a radiation sensitive, gelatin-based, silver-containing coating, which method is capable of giving economic recovery of silver removed from the substrate. Most particularly, the present invention seeks to provide such a method in respect of a radiation sensitive device which comprises an exposed and developed printing plate precursor.

The present invention further seeks to provide a method for the removal of a gelatin-based silver-containing coating from a substrate, and the subsequent recovery of the silver in a convenient form, such method facilitating efficient removal of the silver and recycling of the wash liquor and permitting continuous, in-line operation of the system whilst having no adverse effect on the efficiency of substrate decoating.

According to one aspect of the present invention, there is provided a method of removing a gelatin-based silver-containing coating from an exposed and developed printing plate precursor comprising said coating and a substrate, and subsequently recovering the silver, which method comprises: treating said exposed and developed printing plate precursor with a wash liquor, thereby to remove the coating from the substrate and to flocculate the silver; separating the flocculated silver; recovering the silver; and recirculating the wash liquor for the treatment of further exposed and developed printing plate precursors, characterised in that the wash liquor comprises an aqueous solution containing an enzyme capable of causing degradation of the gelatin, and a flocculating agent, and in that the method is a continuous process for the recovery of silver and the processing of printing plates.

In a particularly preferred embodiment of the invention, said exposed and developed printing plate precursor is transferred to a separate tank containing an aqueous solution, in which the non-useful silver is physically removed by a scrubbing action, or by the action of jets of the solution. The substrate may then pass through a rinsing section to remove any remaining non-useful silver and also through any subsequent processing stages necessary for the production of the printing plate. Other process stages can be included between the development and the wash-off stages depending on the type of printing plate concerned. For example, in a masked system, fixation, rinsing, drying and re-exposure stages may be introduced between development and washing.

The liquor from the wash off stages contains silver and gelatin, plus any other additives such as dyes, polymers etc. which may be present in the washed off coating.

Accordingly, a further aspect of the present invention provides a method of processing a printing plate precursor comprising a substrate coated with a radiation sensitive composition including silver halide and a gelatin-containing binder, which method comprises:
(i) imagewise exposing the coating to radiation;
(ii) applying developer to cause (a) the silver halide in the exposed areas to be chemically developed so as to form metallic silver dispersed in the gelatin-containing binder, and (b) the silver halide in the non-exposed areas to dissolve and diffuse, in the form of silver complexes, to a nucleation layer so as to form the metallic silver printing image by reduction of the complexes;
(iii) washing the printing plate precursor with an aqueous washing solution, thereby to remove the coating from the substrate to form a flocculated suspension of metallic silver, and recovering the suspension;
(iv) separating the silver from the suspension;
(v) recirculating the washing solution; and
(vi) repeating steps (i) to (v) with further precursors, as desired, characterised in that said washing solution comprises an aqueous solution containing an enzyme capable of causing degradation of the gelatin and a flocculating agent, and in that the method is a continuous process for the recovery of silver and the processing of printing plates.

The flocculated silver can be removed by filtration. Various types of filter and filtration methods, such as cloth, bag, cartridge, membrane, paper, ceramic etc, can be used. The preferred method is to circulate the flocculated silver-containing wash liquor through a polypropylene fibre cartridge filter. The nominal pore size of the filter can be in the range 0.1-150 microns, preferably 1-20 microns. The flocculated silver is rapidly removed on filtration of the wash liquor. Concentrations of silver less than 1 mg/litre can be readily achieved. The filtered wash liquor can be recycled many times until the build up of other materials such as developer, gelatin break down products, etc., prevent further use.

It is, thus, a feature of the invention that the method of the invention may be applied to the continuous processing of a plurality of printing plate precursors over a period of time, without the necessity for regular replacement of the wash liquor. Consequently, the method provides significant advantages in terms of economy, efficiency and environmental considerations.

The enzyme used in the method of the present invention must be capable of causing degradation of the gelatin present in the system under the prevalent conditions at the time of treatment and is chosen from that class of enzymes which specifically catalyse the breakdown of proteins. Thus, the gelatin will degrade to form a mixture of lower molecular weight breakdown products. Examples of suitable enzymes include bromelain, chymotrypsin, ficin, papain, pepsin, peptidase, trypsin and the bacterial proteases; these are described by R E Jacobson, J Phot. Sci, 23, 240-248 (1975). Since the wash liquor may be alkaline due to contamination with residual developer solution, enzymes able to act in alkaline solution are preferred. Particularly preferred enzymes are trypsin, bacterial proteases, ficin and chymotrypsin. Especially preferred because of their rapid action are the bacterial proteases known as alkaline proteases. A suitable example is the serine proteinase of the 'Carlsberg' type, IUB number 3.4.21.14, produced by the fermentation of Bacillus licheniformis. Commercial examples of this enzyme are Proteinase D (Rhone-Poulenc) or Esperase 8.0 L (Novo Enzymes).

The flocculating agent of the invention is capable of flocculating the silver only when the gelatin has been substantially degraded by the enzyme. Such a delay in flocculation whilst the enzyme is acting on the gelatin is desirable since this allows substrate decoating to occur before the flocculating agent can have an effect. The length of this delay is not critical and can be varied from fractions of a second to several minutes by varying the conditions, enzyme type and concentration. Consequently, in contrast to the prior art processes, decoating remains unaffected by the flocculating agent.

Flocculating agents of four general types are suitable for the purposes of the invention:
1. Inorganic cations
2. Cationic polymers
3. Cationic surfactants
4. Mercapto compounds

Monovalent inorganic cations such as Na⁺ are only effective in high concentrations and, as such, are not particularly useful. Furthermore, polyvalent cations, such as Al³⁺, are not soluble at the alkaline pH values likely to be encountered, and are also capable of flocculating the silver in the absence of enzyme, and hence are not preferred. The most preferred inorganic cations, therefore, are divalent cations such as Ca²⁺ and Mg²⁺.

Suitable cationic polymers preferably contain a quaternary ammonium group and are described by A D Jenkins, Progress in Polymer Science, Vol 4, (1975) and in US Patent No. 3,288,770. Examples include quaternised derivatives such as Glokill PQ (Rhone-Poulenc), the quaternised polyacrylamide Magnafloc 1597 (Allied Colloids), and, most preferably, poly(1,1-dimethyl-3,5-dimethylenepiperidinium chloride), also known as poly(diallyldimethylammonium chloride) and commercially available as Merquat 100 (Chemviron).

Suitable cationic surfactants include those described in US Patent No. 4,318,818. Examples include decyltrimethylammonium bromide, dodecyltrimethylammonium chloride, myristyltrimethylammonium bromide, cetylpyridinium chloride, trioctylmethylammonium chloride, N-cetyl-N-ethylmorpholinium ethosulphate, didodecyldimethylammonium chloride dodecylethyldimethylammonium chloride, benzyldimethyltetradecylammonium chloride, benzyldimethyloctadecylammonium chloride, benzyldimethyloleylammonium chloride, dodecyldimethyl-3,4-dichlorobenzylammonium chloride and diisobutylphenoxyethoxyethyldimethylammonium chloride. Preferred surfactants are the alkylbenzyldimethylammonium type, such as benzyldimethyltetradecylammonium chloride or benzyldimethyllaurylammonium chloride, also known as benzalkonium chloride. Commercial materials of this type are Glokill RP (Rhone-Poulenc), Arquad B50 (Akzo chemicals), Empigen BCB50 (Albright and Wilson), Synprolam 35DMBQC (ICI) and Hyamine 3500 (Rohm and Haas).

Suitable mercapto compounds are those which adsorb strongly to silver, examples being 2-mercaptobenzothiazole sodium salt, 2-mercaptobenzimidazole sodium salt, thiourea, allylthiourea, phenylthiourea, 5-dodecylhexahydro-s-triazine-2-thione and, preferably, phenylmercaptotetrazole.

The amount of enzyme and flocculating agent present can be varied quite widely without adverse effects on the flocculation of the silver or the decoating of the plate. Generally each gram of gelatin in the wash liquor needs 0.001 to 10 g, preferably 0.01 to 2.0 g, of enzyme and each gram of silver needs 0.01 to 10 g, preferably 0.1 to 0.5 g of flocculating agent. The level of silver in the wash liquor may be established by means of standard analytical techniques, such as atomic absorption spectroscopy.

The enzyme and flocculating agent may be added to the wash liquor as solids or solutions, and may be added individually or as a mixture. Mixtures of enzymes and cationic surfactant are used in detergent compositions, for example as described in US Patent No. 4,318,818. An example of a commercially available mixture is Enzyme Quat (Rhone-Poulenc); the normal use for this material is in cleaning and sanitising operations. Mixtures of enzymes and cationic surfactant or mercapto compounds are also useful at the finishing stage for increasing the oleophilicity of DTR type printing plates, as described in European Patent No. 131,462.

Other materials may be mixed with the enzyme and flocculating agent to aid filtration and flocculation, for example enzyme stabilisers, bactericides, corrosion inhibitors, antifoaming agents and the like.

The following experiments were conducted to illustrate the invention.

### Experiment 1

### Test A

A silver chlorobromide emulsion in gelatin binder having a silver to gelatin weight ratio of 1:1 was coated onto a grained and anodised aluminium substrate which had been dipped in a 1% solution of a Carey Lea silver sol. The coating weight of the emulsion was 1.3 gm m⁻² expressed as silver. The system thus constituted an integral DTR assembly. After imagewise exposure the plate was developed for 30 seconds at 20°C in the following developer solution.

| | |
|---|---|
| 110 gm/l | sodium sulphite |
| 20 gm/l | hydroquinone |
| 6 gm/l | 1-phenyl-3-pyrazolidone |
| 20 gm/l | sodium hydroxide |
| 10 gm/l | sodium thiosulphate |
| 30 ml/l | 2-methylaminoethanol |
| 12 gm/l | sodium carboxymethylcellulose (CMC) |

This gave chemically reduced silver in the exposed areas and physically reduced silver attached to the anodised aluminium in the non-exposed areas. After processing, the plate was transferred to a wash section comprising scrub rollers and liquid jets at 32°C. This removed the loose material from the plate which comprised silver metal, gelatin, developer and silver complexes. The wash liquor was retained after processing several pieces of plate. The final silver content of the wash liquor was 0.86 gl⁻¹. The wash liquor was pumped through a 1 micron Hytrex spun polypropylene fibre cartridge filter (Osmonics Inc., Minnetonka, USA). The wash liquor was recycled. The silver content was measured with time.

### Test B

Test A was repeated but with the addition of the enzyme Proteinase D to the wash liquor at a concentration of 1.0 gl⁻¹.

### Test C

Test A was repeated but with the addition of 0.4 gl⁻¹ benzyldimethyltetradecylammonium chloride.

### Test D

Test A was repeated but with the addition of 1.0 gl⁻¹ Proteinase D and 0.4 gl⁻¹ benzyldimethyltetradecylammonium chloride. The results of this experiment can be seen in Table 1 from which it is apparent that efficient recovery of silver is only possible in the presence of both the enzyme and the flocculating agent.

**TABLE 1**

| Filtration time, hours | Silver in wash liquor mgl⁻¹ | | | |
|---|---|---|---|---|
| | A | B | C | D |
| 0 | 860 | 860 | 860 | 860 |
| 1 | 780 | 540 | 800 | 80 |
| 2 | 730 | 250 | 740 | 10 |
| 3 | 690 | 140 | 660 | 0 |
| 4 | 650 | 100 | 600 | 0 |

### Experiment 2

Plates were processed as in experiment 1. Various flocculating agents and enzymes as listed in Table 2 were tested in the wash liquor. The wash liquor was pumped through a 1 micron Hytrex filter (as in experiment 1) and recycled. The ease of plate decoating and filtration effectiveness were noted.

**TABLE 2**

| Test | Flocculating agent and/or enzyme | Ease of decoating | Filtration effectiveness |
|---|---|---|---|
| 1 | None | Good | Poor |
| 2 | 0.5% Al₂(SO₄)₃ | Poor | Good |
| 3 | 1% Fe₂(SO₄)₃ | Poor | Good |
| 4 | 0.1% Proteinase D | Very good | Poor |
| 5 | 1% CaCl₂ | Good | Poor |
| 6 | 0.2% Merquat 100 | Good | Poor |
| 7 | 0.2% Glokill RP | Good | Poor |
| 8 | 0.1% Phenylmercapto tetrazole | Good | Poor |
| 9 | 0.1% Proteinase D + 1% CaCl₂ | Very good | Good |
| 10 | 0.1% Proteinase D + 0.2% Merquat 100 | Very good | Very good |
| 11 | 0.1% Proteinase D + 0.2% Glokill RP | Very good | Very good |
| 12 | 0.1% Proteinase D + 0.1% Phenylmercaptotetrazole | Very good | Good |
| 13 | 0.1% Proteinase D + 0.5% Al₂(SO₄)₃ | Poor | Good |
| 14 | 0.05% Trypsin (Novo porcine 2500K) | Very good | Poor |
| 15 | 0.05% Trypsin + 1% CaCl₂ | Very good | Good |

Tests 9, 10, 11, 12 and 15 illustrate that both effective removal of the coating and good flocculation are achieved only in the presence of both the enzyme and the flocculating agent.

### Experiment 3

A silver chlorobromide gelatin emulsion as used in experiment 1 was coated onto a commercially available positive-working printing plate (AMAZON, DuPont Howson) at a total coat weight of 4.0 gm⁻². The assembly was imagewise exposed and developed for 30 seconds at 30°C in the following developer:

| | |
|---|---|
| 50 gm/l | sodium sulphite |
| 90 gm/l | sodium carbonate |
| 3 gm/l | 1-phenyl-3-pyrazolidone |
| 12 gm/l | hydroquinone |
| 2 gm/l | potassium bromide |

The plate was then rinsed in an acid stop-bath and subjected to a uniform UV exposure sufficient to expose the underlying positive working diazo layer. After this the plate was transferred to a wash section comprising scrub rollers and water jets as in experiment 1 to remove the top-coat of silver, silver halide and gelatin. The plate was subsequently developed in a 10% solution of sodium metasilicate to remove the exposed areas of the diazo, leaving a final negative image on the plate.

(Alternatively, after first development the plate could be fixed in a thiosulphate solution (eg. 20% sodium thiosulphate + 2% sodium sulphite) to dissolve undeveloped silver).

Various flocculating agents were tested in the wash liquor, as shown in Table 3. The wash liquor was pumped through a 10 micron Hytrex filter and recycled. The ease of decoating of the silver halide layer and the effectiveness of filtration were noted.

**TABLE 3**

| Flocculating agent and/or enzyme | Ease of decoating | Filtration efficiency |
|---|---|---|
| None | Good | Poor |
| 1% Al₂(SO₄)₃ | Poor | Good |
| 0.1% Proteinase D | Very good | Poor |
| 0.5% Hyamine 2389 | Good | Poor |
| 0.1% Proteinase D + 0.5% Hyamine 2389 | Very good | Very good |

Hyamine 2389 is a 50% solution of methyldodecylbenzyltrimethylammonium chloride and methyldodecylxylylenebistrimethylammonium chloride (Rohm and Haas). From the above experiment, it will be appreciated that both effective removal of the coating and good flocculation are achieved only when the enzyme and the flocculating agent are used in combination.

### Experiment 4

Plates were developed as in experiment 1. After development, the plates were transferred to a wash section comprising scrub rollers and water jets, and containing 30 litres of water at 32°C. This removed loose material, which comprised silver metal, gelatin, silver complexes and developer, from the plates. The following flocculant mixture was then added to the wash water, at a rate of 1-6 ml/m² of plate, from an automatic dosing system triggered by the processing of the plate.

| | |
|---|---|
| 250 ml | Merquat 100 |
| 25 ml | Alcalase 2.5L |
| 450 ml | Glycerol |
| 25 ml | Bacteron B6 |
| 0.5 g | Victoria Blue B |
| 250 ml | Water |

In this formulation, the enzyme is Alcalase 2.5L, which is a bacterial protease supplied by Novo Nordisk; glycerol is added as an enzyme stabiliser; Bacteron B6 is a biocide supplied by Bactria Biocides.

The wash water was pumped through a 5 micron, 50 cm Purtrex polypropylene filter (Osmonics Inc., Minnetonka, USA) and recycled. Substantially all of the silver was removed from the wash water. After 100 m² of plate had been processed, the filter became blocked with silver. A new filter was fitted and the process continued. The blocked filter could be sent off for silver recovery. A total of 400 m² of plate could be processed before the wash water needed changing due to build up of developer and other contaminants.

Without the silver removal, the wash water would become unusable after about 20 m² of plates.

## Claims

1. A method for removing a gelatin-based silver-containing coating from an exposed and developed printing plate precursor comprising said coating and a substrate, and subsequently recovering the silver, which method comprises: treating said exposed and developed printing plate precursor with a wash liquor, thereby to remove the coating from the substrate and to flocculate the silver; separating the flocculated silver; recovering the silver; and recirculating the wash liquor for the treatment of further exposed and developed printing plate precursors, characterised in that the wash liquor comprises an aqueous solution containing an enzyme capable of causing degradation of the gelatin, and a flocculating agent, and in that the method is a continuous process for the recovery of silver and the processing of printing plates.

2. A method of processing a printing plate precursor comprising a substrate coated with a radiation-sensitive composition including silver halide and a gelatin-containing binder, which method comprises:
(i) imagewise exposing the coating to radiation;
(ii) applying developer to cause (a) the silver halide in the exposed areas to be chemically developed so as to form metallic silver dispersed in the gelatin-containing binder, and (b) the silver halide in the non-exposed areas to dissolve and diffuse, in the form of silver complexes, to a nucleation layer so as to form the metallic silver printing image by reduction of the complexes;
(iii) washing the printing plate precursor with a washing solution, thereby to remove the coating from the substrate to form a flocculated suspension of metallic silver, and recovering the suspension;
(iv) separating the silver from the suspension;
(v) recirculating the washing solution; and
(vi) repeating steps (i) to (v) with further precursors as desired, characterised in that said washing solution comprises an aqueous solution containing an enzyme capable of causing degradation of the gelatin, and a flocculating agent, and in that the method is a continuous process for the recovery of silver and the processing of printing plates.

3. A method as defined in either of claims 1 or 2 wherein the silver is physically removed by a scrubbing action, or by the action of jets of the wash liquor.

4. A method as defined in any of claims 1-3 wherein the flocculated silver is removed by filtration.

5. A method as defined in any of claims 1-4 wherein the enzyme is bromelain, chymotrypsin, ficin, papain, pepsin, peptidase, trypsin or a bacterial protease.

6. A method as defined in claim 5 wherein the bacterial protease is an alkaline protease.

7. A method as defined in any of claims 1-4 wherein the flocculating agent is an inorganic cation, a cationic polymer, a cationic surfactant or a mercapto compound.

8. A method as defined in claim 7 wherein the flocculating agent is calcium chloride, poly(1,1-dimethyl-3,5-dimethylenepiperidinium chloride), benzyltrimethyltetradecylammonium chloride, phenylmercaptotetrazole, or a combination of methyldodecylbenzyltrimethylammonium chloride and methyldodecylxylylenebistrimethylammonium chloride.

9. A method as defined in any of claims 1-8 wherein the wash liquor comprises 0.001 to 10 g of enzyme per gram of gelatin and 0.01 to 10 g of flocculating agent per gram of silver therein.

## Patentansprüche

1. Ein Verfahren zur Entfernung einer Silberschicht auf Gelatinebasis von einem belichteten und entwickelten, die Schicht und ein Substrat enthaltenden Druckplattenvorläufer und die darauffolgende Rückgewinnung des Silbers, wobei dieses Verfahren folgende Stufen umfaßt : die Verarbeitung des belichteten und entwickelten Druckplattenvorläufers mit einer Waschflüssigkeit, wobei die Schicht vom Substrat entfernt und das Silber geflockt wird, die Abtrennung der Silberausflockung, die Rückgewinnung des Silbers und das in den Kreislauf Zurückführen der Waschflüssigkeit zwecks der Verarbeitung weiterer belichteter und entwickelter Druckplattenvorläufer, dadurch gekennzeichnet, daß die Waschflüssigkeit eine wäßrige Lösung mit einem Enzym, das Zersetzung der Gelatine auszulösen vermag, und einem Ausflockungsmittel enthält und das Verfahren ein kontinuierliches Verfahren zur Rückgewinnung von Silber und Verarbeitung von Druckplatten ist.

2. Verfahren zur Verarbeitung eines Druckplattenvorläufers, der ein mit einer strahlungsempfindlichen Zusammensetzung überzogenes Substrat enthält, wobei die strahlungsempfindliche Zusammensetzung Silberhalogenid und ein gelatinehaltiges Bindemittel enthält und das Verfahren folgende Stufen umfaßt :
(i) die bildmäßige Strahlungsbelichtung der Schicht,
(ii) den Auftrag von Entwickler, wodurch (a) das Silberhalogenid in den belichteten Bereichen chemisch entwickelt wird und im gelatinehaltigen Bindemittel dispergiertes Metallsilber bildet und (b) das Silberhalogenid in den unbelichteten Bereichen gelöst wird und in Form von Silberkomplexen zu einer keimbildenden Schicht überdiffundiert, um darin durch Reduktion der Silberkomplexe das Metallsilberdruckbild zu erzeugen,
(iii) das Waschen des Druckplattenvorläufers mit einer Waschlösung, wobei die Schicht vom Substrat entfernt wird und eine geflockte Metallsilbersuspension bildet, und die Rückgewinnung der Suspension,
(iv) die Abtrennung des Silbers aus der Suspension,
(v) das in den Kreislauf Zurückführen der Waschlösung, und
(vi) nach Wunsch die Wiederholung der Stufen (i) bis (v) mit weiteren Druckplattenvorläufern,
dadurch gekennzeichnet, daß die Waschlösung eine wäßrige Lösung mit einem Enzym, das Zersetzung der Gelatine auszulösen vermag, und einem Ausflockungsmittel enthält und das Verfahren ein kontinuierliches Verfahren zur Rückgewinnung von Silber und Verarbeitung von Druckplatten ist.

3. Verfahren nach Anspruch 1 oder 2, dadurch gekennzeichnet, daß das Silber auf physikalischem Wege durch Scheuern oder Wasserstrahlen der Waschflüssigkeit entfernt wird.

4. Verfahren nach irgendeinem der Ansprüche 1 bis 3, dadurch gekennzeichnet, daß die Silberausflockung abfiltriert wird.

5. Verfahren nach irgendeinem der Ansprüche 1 bis 4, dadurch gekennzeichnet, daß als Enzym Bromelain, Chymotrypsin, Ficin, Papain, Pepsin, Peptidase, Trypsin oder eine bakterielle Protease ausgewählt wird.

6. Verfahren nach Anspruch 5, dadurch gekennzeichnet, daß die bakterielle Protease eine alkalische Protease ist.

7. Verfahren nach irgendeinem der Ansprüche 1 bis 4, dadurch gekennzeichnet, daß das Ausflockungsmittel ein anorganisches Kation, ein kationisches Polymeres, ein kationisches Tensid oder eine Mercaptoverbindung ist.

8. Verfahren nach Anspruch 7, dadurch gekennzeichnet, daß das Ausflockungsmittel Calciumchlorid, Poly(1,1-dimethyl-3,5-dimethylenpiperidiniumchlorid, Benzyltrimethyltetradecylammoniumchlorid, Phenylmercaptotetrazol oder eine Kombination von Methyldodecylbenzyltrimethylammoniumchlorid und Methyldodecylxylylenbistrimethylammoniumchlorid ist.

9. Verfahren nach irgendeinem der Ansprüche 1 bis 8, dadurch gekennzeichnet, daß die Waschflüssigkeit zwischen 0,001 und 10 g Enzym pro Gramm Gelatine und zwischen 0,01 und 10 g Ausflockungsmittel pro Gramm Silber enthält.

## Revendications

1. Une méthode pour enlever une couche gélatineuse à l'argent d'un précurseur de plaque d'impression exposé et développé qui comprend ladite couche et un substrat, et pour récupérer ensuite l'argent, laquelle méthode comprend: traiter ledit précurseur de plaque d'impression exposé et développé avec un liquide de lavage, visant à enlever ainsi la couche du substrat et à floculer l'argent; séparer l'argent floculé; récupérer l'argent; et recirculer le liquide de lavage pour le traitement d'autres précurseurs de plaque d'impression exposés et développés,
caractérisée en ce que le liquide de lavage comprend une solution aqueuse contenant une enzyme qui est capable de causer la dégradation de la gélatine, et un floculant, et en ce que la méthode est un procédé continu pour la récupération d'argent et le traitement de plaques d'impression.

2. Une méthode pour traiter un précurseur de plaque d'impression comprenant un substrat qui est enduit d'une composition sensible aux rayonnements qui contient de l'halogénure d'argent et un liant à la gélatine, laquelle méthode comprend les phases consistant à:
(i) exposer en forme d'image la couche à un rayonnement;
(ii) appliquer du révélateur dans le but (a) de développer chimiquement l'halogénure d'argent dans les zones exposées pour former de l'argent métallique dispersé dans le liant contenant de la gélatine, et (b) de dissoudre l'halogénure d'argent dans les zones non exposées et de le diffuser, sous forme de complexes d'argent, vers une couche de nucléation pour former l'image d'impression d'argent métallique par la réduction des complexes;
(iii) laver le précurseur de plaque d'impression avec une solution de lavage aqueuse, afin d'enlever la couche du substrat pour former une suspension floculée d'argent métallique, et récupérer la suspension;
(iv) séparer l'argent de la suspension;
(v) remettre en circulation la solution de lavage; et
(vi) répéter les étapes (i) à (v) avec d'autres précurseurs, selon le besoin,
caractérisé en ce que ladite solution de lavage comprend une solution aqueuse contenant une enzyme capable de causer la dégradation de la gélatine, et un floculant, et en ce que la méthode est un procédé continu pour la récupération d'argent et le traitement de plaques d'impression.

3. Une méthode selon l'une quelconque des revendications 1 et 2, caractérisée en ce que l'argent est physiquement enlevé par une action de frottage, ou par l'action de jets de liquide de lavage.

4. Une méthode selon l'une quelconque des revendications 1 à 3, caractérisée en ce que l'argent floculé est enlevé par filtration.

5. Une méthode selon l'une quelconque des revendications 1 à 4, caractérisée en ce que l'enzyme est de la bromelaine, de la chymotripsine, de la ficine, de la papaïne, de la pepsine, de la peptidase, de la trypsine ou une protéase bactérielle.

6. Une méthode selon la revendication 5, caractérisée en ce que la protéase bactérielle est une protéase alcaline.

7. Une méthode selon l'une quelconque des revendications 1 à 4, caractérisée en ce que le floculant est un cation inorganique, un polymère cationique, un tensio-actif cationique ou un composé mercapto.

8. Une méthode selon la revendication 7, caractérisée en ce que le floculant est du chlorure de calcium, du poly(chlorure de 1,1-diméthyl-3,5-diméthylènepipéridinium), du chlorure de benzyltriméthyltétradécylammonium, du phénylmercaptotétrazole, ou une combinaison de chlorure de méthyldodécylbenzyltriméthylammonium et de chlorure de méthyldodécylxylylènebistriméthylammonium.

9. Une méthode selon l'une quelconque des revendications 1 à 8, caractérisée en ce que le liquide de lavage comprend de 0,001 à 10 g d'enzyme par gramme de gélatine et de 0,01 à 10 g de floculant par gramme d'argent.
